Europäisches Patentamt

European Patent Office

Office européen des brevets

(19)

(11) **EP 0 874 458 A2**

(12) **EUROPÄISCHE PATENTANMELDUNG**

(43) Veröffentlichungstag:
   **28.10.1998 Patentblatt 1998/44**

(51) Int. Cl.⁶: **H03H 17/02**

(21) Anmeldenummer: 98103979.5

(22) Anmeldetag: **06.03.1998**

(84) Benannte Vertragsstaaten:
   **AT BE CH DE DK ES FI FR GB GR IE IT LI LU MC NL PT SE**

(30) Priorität: **21.04.1997 DE 19716452**

(71) Anmelder: **ROBERT BOSCH GMBH**
   **70442 Stuttgart (DE)**

(72) Erfinder: **Schuller, Gerald**
   **30169 Hannover (DE)**

(54) **Datenreduzierte Kodierung von zeitlich veränderlichen Signalen mit Filterbänken**

(57)    Die Erfindung betrifft ein Verfahren zum Betreiben einer Filterbankanordnung zur datenreduzierten Kodierung von zeitlich veränderlichen Signalen, insbesondere Audiosignalen, mit einer von einem zu kodierenden Signal beaufschlagten und ein kodiertes Ausgangssignal erzeugenden Analyse-Filterbank und einer von diesem Ausgangssignal beaufschlagten Synthese-Filterbank zur Rekonstruktion des ursprünglichen Signals. Um Verzerrungen, wie etwa Vorechos durch die Signalübertragung zwischen der Analyse-Filterbank und der Synthese-Filterbank zu vermeiden, ist erfindungsgemäß vorgesehen, daß die Filterbänke in Kombination bzw. alternativ wie folgt betrieben werden:

a) die Filteranzahl N wird in Abhängigkeit vom Signal während der Signalverarbeitung in den Filterbänken geändert (vergrößert bzw. verkleinert),

b) die Filterlänge L wird in Abhängigkeit vom Signal während der Signalverarbeitung in den Filterbänken geändert (vergrößert bzw. verkleinert),
c) die Filterstruktur wird in Abhängigkeit vom Signal während der Signalverarbeitung in den Filterbänken geändert (vergrößert bzw. verkleinert),

   wobei in der Betriebsart a) und/oder b) während der Umschaltung der Filteranzahl N die Filterimpulsanworten, die zu Filterbänken mit unterschiedlichen N gehören, sich überlappend ausgegeben werden.

## Fig.1

**Beschreibung**

Die Erfindung betrifft die datenreduzierte Kodierung von zeitlich veränderlichen Signalen mit Filterbänken. Insbesondere betrifft die Erfindung ein Verfahren zum Betreiben einer Filterbankanordnung zur datenreduzierten Kodierung von zeitlich veränderlichen Signalen nach dem Oberbegriff des Anspruchs 1 und eine Filterbankanordnung zur Durchführung dieses Verfahrens gemäß dem Oberbegriff von Anspruch 5.

Stand der Technik

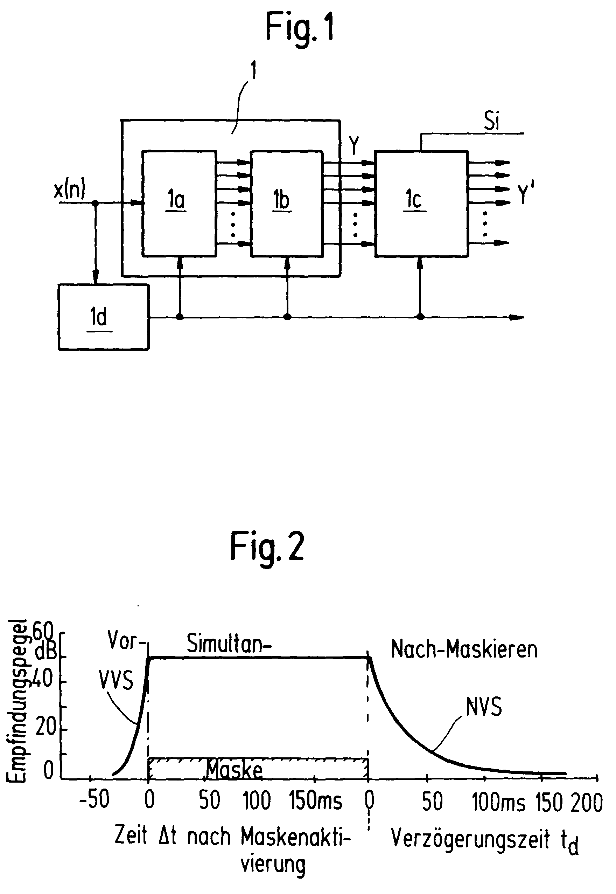

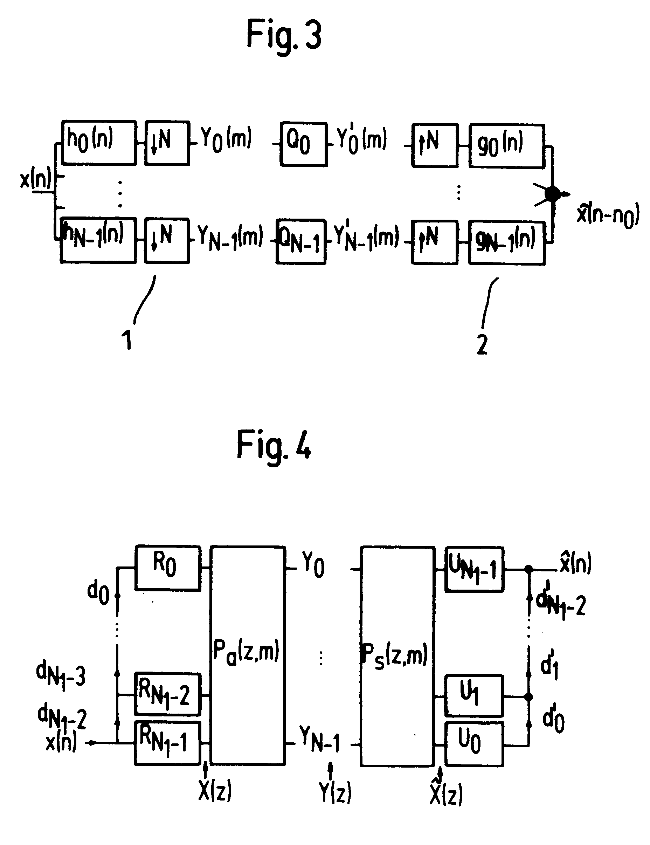

Für die datenreduzierte Kodierung von Audiosignalen werden Filterbänke eingesetzt. Zur Erläuterung bisheriger Filterbänke für die Kodierung von Audiosignalen wird auf Figur 1 und 3 Bezug genommen. Figur 1 zeigt das Blockschaltbild eines herkömmlichen Audiokodierers mit zeitlich veränderlicher Filterbank, Figur 2 zeigt die zeitliche Verdeckungsschwelle des menschlichen Ohrs nach Zwicker (E. Zwicker, H. Fastl, "Psychoacoustics - Facts and Models" - Springer-Verlag, 1990), und Figur 3 zeigt das Blockschaltbild einer herkömmlichen Filterbankanordnung, bestehend aus Analyse-Filterbank und Synthese-Filterbank mit N Teilbändern mit kritischer Unterabtastung, exakter Rekonstruktion und Systemverzögerung von $n_0$ Abtastwerten.

Wie aus Figur 1 und 3 hervorgeht, besteht der Audiokodierer aus einer Analyse-Filterbank 1, aufweisend eine Kaskadenstufe 1a und eine Transformationsstufe 1b und mit den Filter-Impulsantworten $h_i(n)$, die ein Eingangssignal $x(n)$ in die Spektralkomponenten $y_i(m)$ zerlegt, und aus einer Synthese-Filterbank 2 mit den Filter-Impulsantworten $g_i(n)$, die aus den Spektralkomponenten $y_i(m)$ das Ausgangssignal

$$\hat{x}\,(n-n_0)$$

erzeugt. Der Transformationsstufe 1b ist außerdem eine Stufe 1c zur adaptiven Quantisierung und Kodierung nachgeschaltet, die die Spektralkomponenten $y_i(m)$ in Komponenten $y'_i(m)$ wandelt. Außerdem ist in Figur 1 eine Stufe 1d gezeigt, die zur Signalsprungerkennung dient und vom Eingangssignal $x(n)$ eingangsseitig beaufschlagt wird und ausgangsseitig jeweils an die Kaskadenstufe 1a und die Transformationsstufe 1b sowie die Stufe 1c zur adaptiven Quantisierung und Kodierung angeschlossen ist, in welche Stufen sie die Prototyperkennung eingibt. Ein weiterer Ausgang der zuletzt genannte Stufe betrifft die Ausgabe einer Seiteninformation, wie symbolisch durch Si angegeben.

Aus Figur 3 geht hervor, daß beide Filterbänke 1 und 2 aus einer Mehrzahl von parallel geschalteten Filtern (Stufen) besteht. In Figur 3 symbolisiert der abwärtsweisende Pfeil ($\downarrow$N) eine Unterabtastung, demnach nur jeder N-te Abtastwert übertragen wird, und der aufwärtsweisende Pfeil ($\uparrow$N) symbolisiert eine Erhöhung der Abtastrate um N durch Einfügen von N - 1 Nullen nach jedem Abtastwert. Q symbolisiert eine Quantisierung mit einem Quantisierungsfehler $y'_i(m)$ - $y_i(m)$ der Spektralkomponenten $y_i(m)$.

Durch Reduzierung der Abtastwerte wird sichergestellt, daß die Summe der Abtastraten nach der Analyse-Filterbank 1 gleich derjenigen des Eingangssignals ist. Durch eine geeignete Wahl der Analyse-Filterbank 1 und der Synthese-Filterbank 2 ist bei abgeschalteter Quantisierung eine exakte Rekonstruktion des Eingangssignals $x(n)$ möglich, jedoch um $n_0$ Abtastwerte verzögert. Bei $n_0$ handelt es sich um die Systemverzögerungszeit der Filterbank 1, 2. Wenn L die einheitliche Länge von Impulsantworten der Analyse-Filterbank 1 und der Synthese-Filterbank 2 ist, beträgt die Systemverzögerungszeit der bisherigen, sogenannten orthogonalen Filterbänken $n_0$ = L - 1 Abtastwerte.

Für eine effiziente Audiokodierung ist es wichtig, Filterbänke mit schmalbandigen Filtern (Bändern der Filterbank) mit hoher Sperrbereichsdämpfung und einer geringen Überlappung zwischen benachbarten Teilbändern zur Verfügung zu haben.

Ein Problem der bisher zur Audiokodierung verwendeten Filterbänke betrifft die Erzeugung hörbarer Verzerrungen, sogenannter Vorechos, wenn impulsartige Signale durch die Filterbänke geschickt werden. Diese Verzerrungen sind eine Folge der Quantisierung der Spektralkomponenten $y_i(m)$. Unter der Annahme, daß das Eingangssignal aus einem einzigen Impuls besteht, wird dieser Impuls durch die Filter(stufen) der Analyse-Filterbank 1 zeitlich über L Abtastwerte ausgedehnt, die der Länge der Impulsantworten der Analyse-Filterbank 1 entsprechen. Nach der Unterabtastung um N sind dies in jedem Teilband L/N zeitlich aufeinanderfolgende Spektralwerte $y_i(m)$. Falls L/N keine ganze Zahl ist, muß je nach Lage des Impulses bezogen auf ein Unterabtastraster auf- oder abgerundet werden. Wenn die Größe der Quantisierungsstufen der Quantisierer Q etwa proportional zur Amplitude der Spektralwerte $y_i(m)$ angenommen wird, ergeben sich für die L/N Spektralwerte eines Teilbandes erhöhte Quantisierungsfehler. Die auf die Analyse-Filterbank 1 folgende Synthese-Filterbank 2 erhöht zunächst die Abtastrate der quantisierten Spektralwerte um den Faktor N durch Einfügen von N - 1 Nullen nach jedem Abtastwert. Diese erhöhten Quantisierungsfehler werden anschließend durch Synthesefilterung mit Filtern der Länge L zeitlich über eine Länge von 2L - 1 Abtastwerten ausgedehnt.

Damit kann zusammenfassend festgestellt werden, daß die von einem Impuls am Eingang der bisherigen Analyse-Filterbank verursachten erhöhten Quantisierungsfehler am Ausgang der Synthese-Filterbank 2 sich über bis zu 2L - 1 Abtastwerte erstrecken. Ein Teil dieser Quantisierungsfehler erscheint dabei zeitlich bereits vor dem rekonstruierten Impuls am Ausgang der Synthese-Filterbank 2. Die Länge dieses Quantisierungsfehleranteils ist kleiner oder gleich der Systemverzögerungszeit $n_0$ der Filterbank. Wenn die sogenannte Vorverdeckungsschwelle VVS des Ohrs (siehe Figur 2) überschritten wird, werden die Quantisierungsfehler als Vorecho hörbar. Wegen der kurzen Anstiegszeit der Verdeckungsschwelle werden die Vorechos um so deutlicher hörbar, je weiter sie zeitlich vor dem Impuls liegen. Aus diesem Grund werden Filterbänke mit kurzer Systemverzögerungszeit benötigt. Quantisierungsfehler, die zeitlich nach dem Impuls auftreten, sind weniger kritisch, weil die Nachverdeckungsschwelle NVS viel langsamer abfällt (Figur 2).

Ein bisheriger Ansatz, hörbare Vorechos zu vermeiden, sieht vor, die Anzahl der Teilbänder klein zu halten. Dies führt zu Filtern mit kurzer Impulsantwort und kurzer Systemverzögerungszeit. Ein Beispiel hierfür ist eine 32-Band-Filterbank gemäß Layer 1 und Layer 2 des MPEG-Standards (ISO/IEC 11172-3, "Information technology - Coding of moving pictures and associated audio for digital storage media at up to about 1,5 Mbit/s - Part 3: Audio", International Standard, 1993). Diese 32-Band-Filterbank hat eine Filterlänge von 512 und eine Systemverzögerungszeit von 511 Abtastwerten. Ein Nachteil der geringen Teilbandanzahl besteht in der dadurch bewirkten Einschränkung der Redundanz- und Irrelevanzreduktion.

Ein weiterer bisheriger Ansatz, hörbare Vorechos zu vermeiden, ist in Layer 3 des MPEG-Standards festgelegt. Die Filterbank gemäß Layer 3 hat 576 Teilbänder mit einer Filterlänge von 1632 und einer Systemverzögerung von 1631 Abtastwerten. Um bei impulsartigen Eingangssignalen hörbare Vorechos zu vermeiden, kann die Anzahl der Teilbänder auf 192 verringert werden. Dadurch wird die Filterlänge auf 864 reduziert, was einer Systemverzögerungszeit der Filterbank von 863 Abtastwerten entspricht. Zusätzlich muß die Quantisierungsstufenhöhe hinreichend klein gehalten werden, was den Nachteil einer erhöhten Bit-Rate mit sich bringt. Ähnliches gilt für den "Advanced Audio Coding"-Kodierer, bei dem es sich um einen vorgeschlagenen Standard von MPEG-2 handelt. Dieser Kodierer hat eine Filterbank von 1024 Bändern mit einer Filterlänge von 2048, welche während des Betriebs auf 128 Bänder bei einer Filterlänge von 256 heruntergeschaltet werden kann.

Die bislang verwendeten Filterbänke zeichnen sich im wesentlichen durch symmetrische Impulsantworten aus, was zur Folge hat, daß Quantisierungsfehler etwa gleichmäßig vor und nach dem verarbeiteten Impuls verteilt sind. In neuerer Zeit wurden auch Konstruktionsmethoden für Filterbänke mit kurzer Systemverzögerungszeit entwickelt. Die bisher bei der Audiokodierung üblichen Filterbänke haben eine Systemverzögerung von L - 1 Abtastwerten.

Vorschläge für Filterbänke mit kurzer Systemverzögerungszeit, d.h. für Filterbänke mit Systemverzögerungen von weniger als L - 1 Abtastwerten finden sich beispielsweise in: K. Nayebi, T. Barnwell, M. Smith, "Low Delay Coding of Speech and Audio Using Nonuniform Band Filter Banks", IEEE Workshop on Speech Coding for Telecom. Sept. 1991; K. Nayebi, T. Barnwell, M. Smith, "Design of Low Delay FIR Analysis-Synthesis Filter Bank Systems", Proc. Conf. on Info. Sci. and Sys., März 1991; K. Nayebi, T.P. Barnwell, III, M.J.T. Smith, "Low Delay FIR Filter Banks: Design and Evaluation", Trans. on Signal Procesing, Januar 1994, S. 24-31. Allerdings ergeben diese Vorschläge keine Filterbänke mit exakter Rekonstruktion, und sie sind insbesondere ungeeignet für einen Entwurf von Filterbänken mit einer Vielzahl von Teilbändern.

Eine sogenannte modulierte Filterbank mit kurzer Systemverzögerungszeit und exakter Rekonstruktion ist in folgenden Druckschriften beschrieben: G. Schuller und M.J.T. Smith, "A General Formulation for Modulated Perfect Reconstruction Filter Banks with Variable System Delay", NJIT 94 Smp. on Appl. of Subbands and Wavelets, März 1994; G. Schuller und M.J.T. Smith, "Efficient Low Delay Filter Banks", DSP Workshop, October 1994; G. Schuller und M.J.T. Smith, "A new Algorithm for Efficient Low Delay Filter Bank Design" ICASSP 95, Detroit, MI, Mai 1995. Bei dieser modulierten Filterbank sind die Teilbandfilter durch Frequenzverschiebung eines sogenannten Basisband-Prototypfilters bestimmt, wobei jeweils eines für die Analyse-Filterbank und die Synthese-Filterbank vorgesehen ist. Dadurch wird die Konstruktion und die Implementierung der Gesamtfilterbank vereinfacht. Diese Filterbänke mit kurzer Verzögerungszeit haben asymmetrische Impulsantworten, welche Quantisierungsfehler ungleichmäßig verteilen, wobei die Mehrzahl der Quantisierungsfilter nach dem Impuls liegt. Dies entspricht einer besseren Anpassung an die Verdeckungseigenschaften des menschlichen Ohrs.

Bei Kodierungsanwendungen ist es nützlich, die Filtercharakteristik und die Anzahl der Bänder (Filter) der Filterbank an die momentane Signaleigenschaft anzupassen. Auf diese Weise kann beispielsweise der Kompressionsgrad oder die Kodiereffizienz erhöht werden. Ein Spezialfall der Umschaltung ist in B. Edler, "Coding of Audio Signals with Overlapping Block Transform and Adaptive Window Functions" (in deutsch), Frequenz, Sept. 1989, S. 252-256, beschrieben. Ein Spezialfall der Umschaltung ist in M. Bosi et al., "Detailed Technical Description of the Dolby Proposal Based on Non Backward Compatible Reference Model Version I", ISO/IEC JTC1/SC29/WG11 MPEG 95/047, Lausanne, Schweiz, März 1995, beschrieben. Beide dieser Übergänge sind für L = 2N und orthogonale Filter festgelegt, d.h. die Analyse-Filterbank und die Synthese-Filterbank sind als zeitlich umgekehrte bzw. inverse Versionen gebildet, und zwar bis auf einen Skalierungsfaktor. Eine weitere Umschaltung ist in R.L. de Queiroz und K.R. Rao", "Variable-Block-Size Lapped Transforms", IEEE Trans. on Sig. Proc., Dez. 1996, beschrieben. Angewendet wird sie auf orthogonale Filter, für längere Filter (L $\geq$ 2N), und es sind Übergangsfilter vorgesehen, die nicht moduliert sind, d.h. die nicht durch ein Paar von Basisband-Prototypfiltern bestimmt sind, was die Qualität des Übergangsfilters deutlich verschlechtert.

Vorteile der Erfindung

Das erfindungsgemäße Verfahren bzw. die erfindungsgemäße Filterbankanordnung hat demgegenüber den Vorteil, daß die Filterbank frei wählbare Systemverzögerungszeiten zwischen N - 1 und 2L - 1 Abtastwerten aufweist (N = Filteranzahl, L = Filterlänge). Hierdurch ist eine exakte Rekonstruktion des Eingangssignals gewährleistet. Außerdem kann die Systemverzögerungszeit in einzelnen Schritten (Abtastzeitpunkte) vor der Unterabtastung gewählt werden. Schließlich ermöglicht die Erfindung die Implementierung einer neuartigen Filterstruktur, die besonders einfach ausgeführt werden kann.

Schließlich betrifft die Erfindung eine neuartige Umschaltbarkeit für die Filterbänke der Filterbankanordnung, wobei Übergangsfilter aus der Umschaltung und der Filterstruktur unter Beibehaltung der exakten Rekonstruktion erhalten werden.

"Nichtorthogonalität" zwischen den Filtern der Analyse-Filterbank und demjenigen der Synthese-Filterbank in der Definition des Anspruchs 1 bedeutet, daß diese beiden Filterarten nicht zeitlich umgekehrte Versionen voneinander sind.

Die erfindungsgemäße Filterbankanordnung ist im Anspruch 5 in Gestalt eines mathematischen Modells für Filterbänke dargestellt. Die Darstellung der komplexen Filterbänke in mathematischer Form ist auf diesem Gebiet der Technik üblich, und dem Fachmann erschließen sich aus dem mathematischen Modell ohne weiteres Schaltungsstrukturen für die Filterbänke.

Mit anderen Worten besteht die Filterbankanordnung zur Durchführung des erfindungsgemäßen Verfahrens bevorzugt aus Blöcken von zwei unterschiedlichen Typen (Maximal- und Minimal-Verzögerungsmatrizen) und einer Transformation der Länge N, die jeweils abhängig vom Signal verändert werden können, aus einer Verschiebungsmatrix und den zu ihnen inversen Blöcken und der inversen Transformation, die so konstruiert sind, daß sich beim Hintereinanderschalten von Analyse- und Synthese-Filterbank eine exakte Rekonstruktion des ursprünglichen Signals ohne Verzerrungen wie beim Stand der Technik ergibt.

Weitere vorteilhafte Ausgestaltungen der Erfindung sind den Unteransprüchen zu entnehmen.

Gemäß einer vorteilhaften Weiterbildung des erfindungsgemäßen Verfahrens ist vorgesehen, daß die Analyse-Filterbank und die Synthese-Filterbank, falls sie direkt miteinander verbunden betrieben werden, ein Signal exakt rekonstruieren.

Das erfindungsgemäße Verfahren und die erfindungsgemäße Filterbankanordnung eignen sich zur Kodierung/Dekodierung von beliebigen zeitlich veränderlichen Signalen, insbesondere jedoch zur entsprechenden Verarbeitung von Audiosignalen, und zwar vor allem zum Einsatz bei der Rundfunk-Signalübertragung, Kabel-Signalübertragung, Satelliten-Signalübertragung und im Zusammenhang mit Aufzeichnungsgeräten.

Zeichnung

Die Zeichnung wird anhand der folgenden Figuren näher erläutert.
Es zeigen:

Figur 1    das Blockschaltbild eines herkömmlichen Audiokodierers mit zeitlich veränderlicher Filterbank,

Figur 2    die zeitliche Verdeckungsschwelle des menschlichen Ohrs nach Zwicker (E. Zwicker, H. Fastl, "Psychoacoustics - Facts and Models" - Springer-Verlag, 1990),

Figur 3    das Blockschaltbild einer herkömmlichen Filterbank mit N Teilbändern mit kritischer Unterabtastung, exakter Rekonstruktion und Systemverzögerung von $n_0$ Abtastwerten,

Figur 4    eine Polyphasen-Darstellung der erfindungsgemäßen Filterbank,

Figur 5    ein Blockbild der erfindungsgemäßen Filterbank mit Analyse-Filterbank und Synthese-Filterbank,

Figur 6    die Struktur der Elemente von Filtermatrizen als Signalflußgraphen,

Figur 7    die Struktur der Elemente von Filtermatrizen als Signalflußgraphen,

Figur 8    Synthese-Übergangsbasisband-Impulsantworten einer zeitlich veränderlichen Filterbank mit niedriger Systemverzögerung für einen Übergang von 1024 Bändern mit einer Filterlänge von 4096 zu 128 Bändern mit einer Filterlänge von 512,

Figur 9 Synthese-Übergangsbasisband-Impulsantworten einer zeitlich veränderlichen Filterbank mit niedriger Systemverzögerung für einen Übergang von 128 Bändern mit einer Filterlänge von 512 zu 1024 Bändern mit einer Filterlänge von 4096,

Figur 10 den Frequenzgang eines Basisband-Prototypen der Filterbank mit 1024 Bändern, einer Filterlänge von 4096 und einer Systemverzögerungszeit von 2047 Abtastwerten, wobei diese Filterbank für die Analyse und Synthese identisch ausgebildet sind,

Figur 11 die Impulsantwort des Basisband-Prototypen mit 1024 Bändern, einer Länge von 4096 und einer Systemverzögerungszeit von 2047 Abtastwerten,

Figur 12 ein Diagramm zum Vergleich der Frequenzgänge des Basisband-Prototypen der 1024-Band-Orthogonalen MPEG-2 Filterbank mit einer Filterlänge von 2048 (gepunktete Linie) mit einer Filterbank niedrigerer Systemverzögerung mit gleicher Systemverzögerung aber einer Filterlänge von 4096,

Figur 13 drei Amplituden-Abtastdiagramme für, von oben nach unten: ein Originalsignal; das Originalsignal, nachdem es den MPEG-2-Kodierer mit Standardverzögerungs-Filterbank durchlaufen hat; das Originalsignal, nachdem es den MPEG-2-Kodierer mit Hiedrigverzögerungs-Filterbank gemäß der vorliegenden Erfindung durchlaufen hat.

Die erfindungsgemäßen Filterbänke bzw. Filterstrukturen werden im folgenden als mathematische Modelle erläutert, ohne auf eine Implementierung in entsprechenden Schaltungen einzugehen, die aufgrund der mathematischen Modelle vom Fachmann ohne weiteres ausgeführt werden kann.

Zunächst wird die Matrixformulierung der Filterbänke definiert.

Um die Filteroperation mit der darauffolgenden Unterabtastung beschreiben zu können, wird folgender zeitabhängiger Vektor der Länge N aus dem Eingangssignal x(n) gebildet

$$\mathbf{x}(m) = [x(mN), \ldots, x(mN + N - 1)]$$

Die N Komponenten des Vektors sind vom (Zeit-)Index m abhängig. Wenn auf diese Komponenten die sogenannte z-Transformation angewendet wird, ergibt sich folgender Vektor:

$$\mathbf{X}(z) = \left[ \sum_{m=0}^{\infty} x(mN) \cdot z^{-m}, \ldots, \sum_{m=0}^{\infty} x(mN + N - 1) \cdot z^{-m} \right]$$

wobei z eine beliebige komplexe Variable ist. Eine Multiplikation der z-Transformierten X(z) mit $z^{-1}$ kann als Zeitverzö-gerung oder Zwischenspeicherung des Zeitsignals x(m) um einen Abtastschritt angesehen werden. In derselben Weise wird mit den Signalen am Ausgang der Analyse-Filterbank verfahren.

$$\mathbf{y}(m) = [y_0(m), \ldots, y_{N-1}(m)]$$

$$\mathbf{Y}(z) = \left[ \sum_{m=0}^{\infty} y_0(m) \cdot z^{-m}, \ldots, \sum_{m=0}^{\infty} y_{N-1}(m) \cdot z^{-m} \right]$$

Die Analyse-Filterbankoperation mit Unterabtastung kann beschrieben werden als

$$Y(z) = X(z) \cdot P_a(z,m)$$

wobei $P_a(z,m)$ die sogenannte Polyphasenmatrix der Analyse-Filterbank ist. Diese Polyphasenmatrix enthält eine Abhängigkeit vom Zeitindex m der niedrigen Abtastrate, weil sie zeitlich variabel ist; es gilt:

$$P_a(z,m) = \begin{bmatrix} P_{0,0}(z,m) & P_{0,1}(z,m) & \cdots & P_{0,N-1}(z,m) \\ P_{1,0}(z,m) & P_{1,1}(z,m) & & \\ \vdots & & \ddots & \\ P_{N-1,0}(z,m) & & & P_{N-1,N-1}(z,m) \end{bmatrix}$$

mit

$$P_{n,k}(z,m) = \sum_{m=0}^{L-1} h_k(N-1-n+mN,m)z^{-m}$$

wobei L die Filterlänge in Blöcken mit der Länge von N Abtastwerten ist.

Die Synthese-Bankfilteroperation mit Erhöhung der Abtastrate läßt sich in ähnlicher Weise beschreiben als:

$$X(z) \cdot z^{-d} = Y(z) \cdot P_s(z,m)$$

wobei $P_s(z)$ die Synthesen-Polyphasenmatrix ist, die wie folgt lautet:

$$P_s(z,m) = \begin{bmatrix} P'_{0,0}(z,m) & P'_{0,1}(z,m) & \cdots & P'_{0,N-1}(z,m) \\ P'_{1,0}(z,m) & P'_{1,1}(z,m) & & \\ \vdots & & \ddots & \\ P'_{N-1,0}(z,m) & & \cdots & P'_{N-1,N-1}(z,m) \end{bmatrix}$$

mit

$$P'_{k,n}(z,m) = \sum_{m=0}^{L-1} g_k(n+mN,m)z^{-m}.$$

Das bisher erläuterte mathematische Modell ist in Figur 4 erläutert, wobei $N = N_1$

$$R_0 = R_1 = \ldots = R_{N1-1} = N_1,$$

$$U_0 = U_1 = \ldots = U_{N1-1} = N_1,$$

$$d_0 = d_1 = \ldots = d_{N1-2} = z^{-1},$$

$$d'_0 = d'_1 = \ldots = d'_{N1-2} = z^{-1}.$$

Soweit die Matrixformulierung der nachgeordneten Filteroperation. Es folgen noch einige hierfür erforderliche Definitionen.

Im folgenden bezeichnen fette Buchstaben Matrizen bzw. Vektoren, Großbuchstaben z-Transformationen bzw. Polynome. ":=" bedeutet "definiert als". Eine Matrix F(z) ist kausal, wenn sie keine Exponenten von z enthält.

I ist die N x N-Identitätsmatrix; **J** ist eine N x N-Anti-Diagonalmatrix; **diag** ist eine N x N-Diagonal-Koeffizenten-Matrix, und **S**(z) ist eine Verschiebungsmatrix, welche einen Vektor oder einen Block um einen Abtastwert verschiebt. Es gilt:

$$
I := \begin{bmatrix} 1 & \cdots & 0 & 0 \\ 0 & \cdots & 0 & 0 \\ \vdots & & \vdots & \vdots \\ 0 & \cdots & 1 & 0 \\ 0 & \cdots & 0 & 1 \end{bmatrix}
$$

$$
J := \begin{bmatrix} 0 & \cdots & 0 & 1 \\ 0 & \cdots & 1 & 0 \\ \vdots & & \vdots & \vdots \\ 1 & \cdots & 0 & 0 \end{bmatrix}
$$

$$
\mathrm{diag}(x_0,\ldots,x_{N-1}) := \begin{bmatrix} x_0 & 0 & \cdots & 0 \\ 0 & x_1 & \cdots & 0 \\ & & \ddots & \vdots \\ 0 & 0 & \cdots & x_{N-1} \end{bmatrix}
$$

$$
S(z) := \begin{bmatrix} 0 & 0 & \cdots & 0 & z \\ 1 & 0 & \cdots & & 0 \\ 0 & 1 & 0 & \cdots & 0 \\ \vdots & & \ddots & & \vdots \\ 0 & \cdots & 0 & 1 & 0 \end{bmatrix}
$$

$[\mathbf{F}]_{n,k}$ ist das Element der n-ten Zeile und k-ten Spalte der Matrix **F**. Bei $\lceil x \rceil$ handelt es sich um die kleinste ganze Zahl größer als oder gleich x. Bei $\lfloor x \rfloor$ handelt es sich um die größte ganze Zahl kleiner als oder gleich x, und

$$
\Pi^{\nu}_{j=1} \mathbf{L}_j := \mathbf{L}_1 \ldots \mathbf{L}_{\nu}.
$$

Nunmehr folgt auf Grundlage der vorstehenden Definitionen, die auch für die Ansprüche 5 ff. gelten, die mathematische Beschreibung der Filterstrukturen.

Als erstes wird die Struktur der Analyse-Filterbank erläutert.

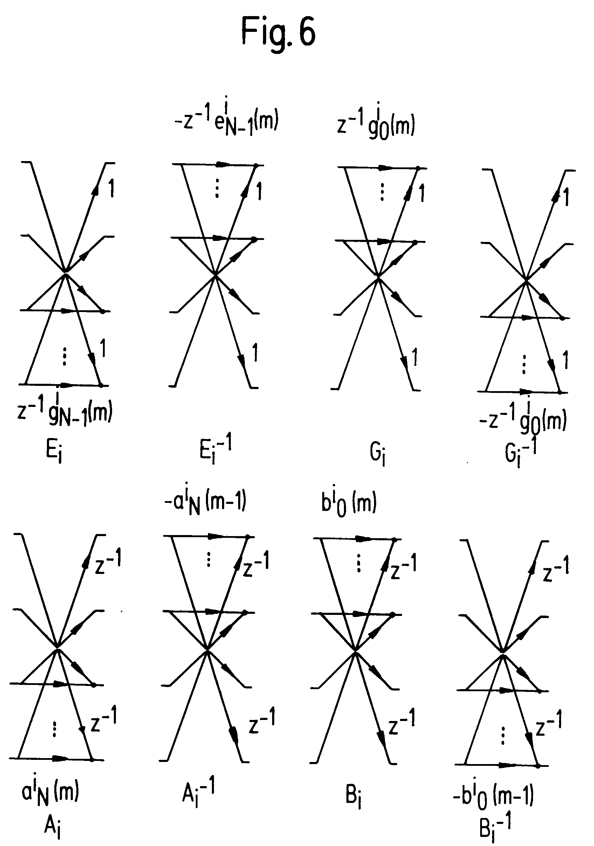

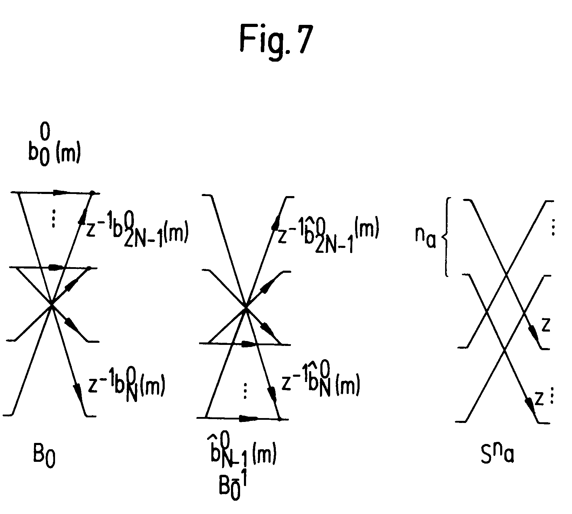

Mit Hilfe der vorstehend angeführten Matrix-Formulierung und den vorstehend genannten Definitionen kann die erfindungsgemäße Filterstruktur nunmehr durch Matrizen und Matrix-Multiplikationen dargestellt werden, und zwar als Kaskade aus einfachen Matrizen oder Filterstrukturen. Das Eingangssignal einer Struktur ist ein Zeilenvektor, der von links mit einer Matrix multipliziert wird. Das Ergebnis der Multipilikation ist der Ausgang der Filterstruktur. Die Filterstrukturen sind analog zu den Strukturen der nachstehend angeführten Matrizen, und sie sind in Figur 6 und 7 dargestellt.

$$E_i(z,m) := J + z^{-1} \cdot \text{diag}(\underbrace{0, \ldots, 0}_{\lceil N/2 \rceil}, e^i_{\lceil N/2 \rceil}(m), \ldots, e^i_{N-1}(m))$$

$$G_i(z,m) := J + z^{-1} \cdot \text{diag}(g^i_0(m), \ldots, g^i_{\lfloor N/2 \rfloor - 1}(m), 0, \ldots, 0)$$

$$A_i(z,m) := z^{-1} \cdot J + \text{diag}(0, \ldots, 0, a^i_{\lceil N/2 \rceil}(m), \ldots, a^i_{N-1}(m))$$

$$B_i(z,m) := z^{-1} \cdot J + \text{diag}(b^i_0(m), \ldots, b^i_{\lfloor N/2 \rfloor - 1}(m), 0, \ldots, 0)$$

$$B_0(z) := [z^{-1} \cdot \text{diag}(b^0_N(m), \ldots, b^0_{2N-1}(m)) \cdot J +$$

$$+ \text{diag}(b^0_0(m), \ldots, b^0_{\lfloor N/2 \rfloor - 1}(m), 0, \ldots, 0)] \cdot J^{i_a}$$

Die Hintereinanderschaltung der Filterstrukturen zu einer Kaskade kann auch als Matrix-Multiplikation dargestellt werden, und die Hintereinanderschaltung führt zur folgenden Analyse-Filterbank:

$$P_a(z,m) :=$$

$$= S^{n_a}(z) \cdot B_0(z,m) \cdot \prod_{i=1}^{\mu-1} H_i(z,m) \cdot \prod_{j=1}^{\nu} L_j(z,m) \cdot T_a(m) \qquad (1)$$

Wobei $H_i$ und $L_i$ definiert sind als

$$H_i(z,m) := B_i(z,m) ,$$

wenn $i_a = 0$; ansonsten gilt

$$H_i(z,m) := A_i(z,m) ,$$

$$L_i(z,m) := E_i(z,m) ,$$

wenn $i_a = 0$ und $\mu$ gerade ist, oder $i_a = 1$ und $\mu$ ungerade ist; ansonsten gilt:

$$L_i(z,m) := G_i(z,m) .$$

Bei $T_a(m)$ handelt es sich um eine Transformationsmatrix der Größe N x N. Die Parameter $\mu > 0$ und $\nu \geq 0$ können frei gewählt werden. Diese Parameter bestimmen die Filterlänge und mit $n_a$, $n_s$ die Systemverzögerungszeit. $i_a$ kann frei gewählt werden als 1 oder 0, hat aber keinen wesentlichen Einfluß auf die Filtercharakteristik. $0 \leq n_a \leq N$ kann zur Fein-einstellung der Systemverzögerungszeit in Schritten der Eingangsabtastrate herangezogen werden. Die Analysefilterung und Unterabtastung werden dargestellt als

$$Y(z) = X(z) \cdot P_a(z,m)$$

Im folgenden wird die Synthese-Filterbank im mathematischen Modell dargestellt.
Die Verwendung der folgenden inversen Matrizen bzw. Strukturen führt zu einer exakten Rekonstruktion:

$$\mathbf{E}_i^{-1}(z,m) =$$

$$\mathbf{J} - z^{-1} \cdot \mathrm{diag}(\epsilon_{N-1}^i(m), \ldots, \epsilon_{\lceil N/2 \rceil}^i(m), 0, \ldots, 0)$$

$$\mathbf{G}_i^{-1}(z,m) =$$

$$\mathbf{J} - z^{-1} \cdot \mathrm{diag}(0, \ldots, 0, g_{\lfloor N/2 \rfloor - 1}^i(m), \ldots, g_0^i(m))$$

$$\mathbf{A}_i^{-1}(z,m) \cdot z^{-2} = z^{-1} \cdot \mathbf{J}$$

$$-\mathrm{diag}(a_{N-1}^i(m-1), \ldots, a_{\lceil N/2 \rceil}^i(m-1), 0, \ldots, 0),$$

$$\mathbf{B}_i^{-1}(z,m) \cdot z^{-2} = z^{-1} \cdot \mathbf{J}$$

$$-\mathrm{diag}(0, \ldots, 0, b_{\lfloor N/2 \rfloor - 1}^i(m-1), \ldots, b_0^i(m-1)),$$

$$\mathbf{B}_0^{-1}(z,m) \cdot z^{-2} =$$

$$\mathbf{J}^{i} [z^{-1} \cdot \mathrm{diag}(\hat{b}_N^0(m), \ldots, \hat{b}_{2N-1}^0(m)) \cdot \mathbf{J} +$$

$$-\mathrm{diag}(0, \ldots, 0, \hat{b}_{\lfloor N/2 \rfloor - 1}^0(m), \ldots, \hat{b}_0^0(m))]$$

mit

$$\hat{b}_j^0(m) = \frac{b_j^0(m\text{-}1)}{b_{N+j}^0(m\text{-}1) b_{2N\text{-}1\text{-}j}^0(m)}$$

für $j = 0, \ldots, N/2\text{-}1$, und $\hat{b}_{N+j}^0(m) = 1/b_{2N\text{-}1\text{-}j}^0(m\text{-}1)$ for $j = 0, \ldots, N\text{-}1$

$$\mathbf{P_s}(z,m) :=$$

$$\mathbf{T_s}(m) \cdot \prod_{j=\nu}^{1} \mathbf{L}_j^{-1}(z,m) \cdot \prod_{i=\mu-1}^{1} \left( \mathbf{H}_i^{-1}(z, m - 2(\mu - 1 - i))z^{-2} \right) \cdot$$

$$\cdot \left( \mathbf{B}_0^{-1}(z, m - 2(\mu - 1))z^{-2} \cdot \mathbf{S}^{n_s}(z) \right) \qquad (2)$$

wobei

$$\mathbf{T_a}(m) \cdot \mathbf{T_s}(m) = \mathbf{I}.$$

Die Synthese-Überabtastung und -filterung ergibt sich als

$$\hat{X}(z) = Y(z) \cdot P_s(z, m)$$

wobei $0 \le n_s \le n_a$. $n_s$ beeinflußt die Systemverzögerungszeit in Abtastschritten der Eingangsabtastrate.

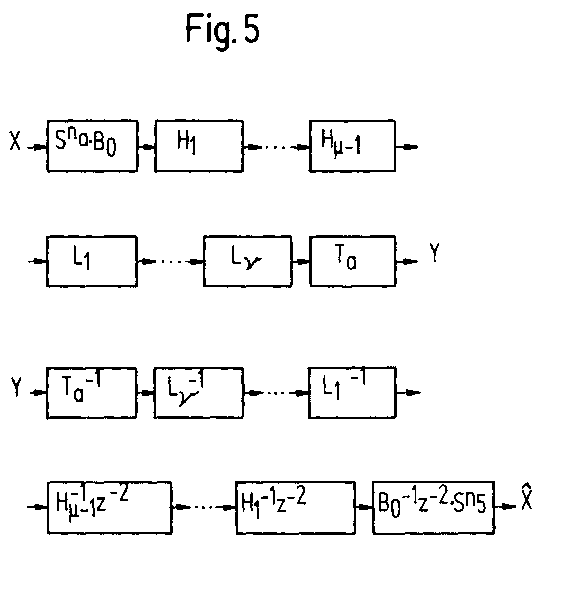

Ein Blockbild der derart aufgebauten Filterbank ist in Figur 5 dargestellt. Die Koeffizienten der Filterstruktur ergeben dabei die Filtercharakteristik. Beispielsweise können die Koeffizienten durch Verwendung der in G.D.T. Schuller und M.J.T. Smith, "New Framework for Modulated Perfect Reconstruction Filter Banks", IEEE Trans. on Sig. Proc., Aug. 1996 erläuterten Optimierung erhalten werden.

Die Unter- und Überabtastung auf Grundlage der vorstehend erläuterten Filter/Filterbänke wird nunmehr für verschiedene Bandanzahlen für den stationären Fall erläutert.

Wenn $N_1$, $N_2$ beliebige Bandanzahlen sind, wobei $N_1 > N_2$ angenommen wird, gilt:

$$X'(z) := X(z) \cdot S^{n_a}(z) \tag{3}$$

Für den Fall $N = N_2$ werden im Vektor $\mathbf{X}(z)$ $N_1 - N_2$ Nullen so plaziert, daß $\mathbf{X}'(z)$ die Nullen symmetrisch um das eigene Zentrum aufweisen, und zwar beispielsweise wie folgt:

$$X'(z) = [X_0'(z), \ldots, X_{N_2/2-1}'(z), \underbrace{0, \ldots, 0}_{N_1 - N_2}, X_{N_2/2}'(z), \ldots, X_{N_2-1}'(z)]$$

Dieses Ergebnis wird dadurch erhalten, daß $\mathbf{R}_i$ (in Figur 4) an der entsprechenden Stelle zu Null gesetzt wird, und $d_i$ an den zugehörigen Stellen zu 1, so daß zwischen zwei $\mathbf{R}_i$, die ungleich Null sind, genau ein Verzögerungselement $z^{-1}$ vorhanden ist. Die Unterabtastrate von $\mathbf{R}_i$, die ungleich Null ist, ist in jedem Moment gleich der Anzahl $\mathbf{R}_i$, die jeweils ungleich Null sind.

Für $N = N_1$ ist $\mathbf{T}_a$ eine invertierbare $N_1$ x $N_1$-Matrix, beispielsweise eine diskrete Kosinustransformation, für die schnelle Algorithmen existieren. Es gilt:

$$T_s(m) = T_a(m)^{-1}.$$

Für $N = N_2$ erscheinen durch Einsetzen der Nullen in $\mathbf{X}(z)$ auch Nullen am Eingang der Transformation. An den Stellen, an welchen eine Null erscheint, wird eine Zeile mit Nullen eingeschoben, so daß sich eine $N_1$ x $N_2$-Transformationsmatrix ergibt. Anhand des vorstehend angeführten Beispiels ergibt dies für die Analyse mit einer Transformation der Größe $N_2$ x $N_2$, die aus einer oberen Hälfte $\mathbf{T}_a$ und einer unteren Hälfte $\mathbf{T}_d$ besteht:

$$T_e = \left[ \begin{array}{c} T_v \\ \hline 0 \\ \hline T_d \end{array} \right] \Bigg\} N_1$$

In der Synthese-Transformationsmatrix werden $N_1$ x $N_2$ Spalten mit Null eingeschoben, so daß diese Spalten symmetrisch um das Zentrum der Matrix angeordnet sind, wodurch sich eine $N_2$ x $N_1$-Transformationsmatrix ergibt. Dies ist auf Grundlage des vorstehend angeführten Beispiels und einer $N_2$ x $N_2$-Synthese-Transformationsmatrix, die aus einer rechten Hälfte $\mathbf{T}_r$ und einer linken Hälfte $\mathbf{T}_l$ besteht:

$$T_s = \left[ \; T_l \; | \; 0 \; | \; T_r \; \right] \Big\} \, N_2$$

Ihr Produkt ist die $N_1 \times N_1$-Matrix

$$T_a \cdot T_s = \left[ \begin{array}{c|c|c} I & & 0 \\ \hline & 0 & \\ \hline 0 & & I \end{array} \right]$$

mit Hilfe der Definition

$$\dot{X}'(z) := \hat{X}(z) \cdot S^{-n_a}(z)$$

ergibt sich, daß

$$\hat{X}'(z)$$

die Nullen an den gleichen Stellen hat wie sich die Spalten mit Nullen in der Synthese-Transformationsmatrix befinden, und

$$\hat{X}(z)$$

wird entsprechend durch $S^{na}(z)$ verschoben. Die Nullen von

$$\hat{X}(z)$$

erhält man, indem das $U_i$ an den entsprechenden Stellen zu Null gesetzt wird, während $d^v_i$ an den zugehörigen Stellen zu 1 gesetzt wird, so daß zwischen zwei $U_i$, die ungleich Null sind, genau ein Verzögerungselement $z^{-1}$ vorliegt. Die Überabtastrate von $U_i$, die ungleich Null sind, ist in jedem Moment gleich der Anzahl derjenigen $U_i$, die ungleich Null sind. Damit haben beide Bandzahlen Signalvektoren der gleichen Größe, und die Beschreibung der zeitlichen Variabilität kann, wie nachfolgend ausgeführt, verwendet werden, um eine exakte Rekonstruktion zu erhalten.

Im einzelnen wird nachfolgend der Übergang bzw. das Umschalten zwischen $N_2$- und $N_1$-Bändern erläutert.

Die Signalvektoren zum Zeitpunkt vor dem Übergang werden als $X_1(z)$ und $X'_1(z)$ (Zustand 1) definiert, und nach dem Übergang als $X_2(z)$ und $X'_2(z)$ (Zustand 2). Ein Übergang erfolgt immer unmittelbar nach der Abtastung oder dem Einlesen der Eingangswerte von $X(z)$ durch $R_i$.

Es folgt eine Erläuterung des Übergangs- bzw. Umschaltens analog zu der einleitend erläuterten Umschaltung (B. Edler), realisiert mit den erfindungsgemäßen Filterstrukturen (Übergang A).

Zunächst wird ein direktes Umschalten von $X'(z)$ zum Zeitpunkt $m_0$ erläutert. Beim Übergang vom Zustand 1 zum Zustand 2 (auf den vorliegend als Übergang A Bezug genommen wird) hat $X'(z)$ die Form von $X'_1(z)$ zum Zeitpunkt $m_{0-1}$ bzw. die Form von $X'_2(z)$ zum Zeitpunkt $m_0$. Um dies zu erreichen, müssen in $X(z)$ die dazu passende Nullen eingefügt werden; d.h. die passenden $R_i$ und $d_i$ müssen zu Null bzw. 1 gesetzt werden, was sich aus der Definition von $X'(z)$ ergibt. Dies führt zu einer unmittelbaren Umschaltung der Anzahl der Bänder, und dies kann zu einer Unterabtastrate und zu einer Anzahl von Signalwerten im Vektor zu einem Zeitpunkt führen, welcher zwischen $N_1$ und $N_2$ liegt. Zum Zeitpunkt, an welchem die Nullen am Eingang der Transformation erscheinen, werden die entsprechenden Zeilen von Nullen eingefügt.

Der Übergang der Synthese ergibt sich entsprechend und durch die Bedingung der exakten Rekonstruktion.

Es folgt eine Erläuterung des Übergangs- bzw. Umschaltens analog zu der einleitend erläuterten Umschaltung (M. Bosi et al.), realisiert mit den erfindungsgemäßen Filterstrukturen (Übergang B).

Das direkte Umschalten von $X(z)$ zum Zeitpunkt $m_0$ wird nunmehr erläutert. Beim Übergang vom Zustand 1 zum Zustand 2 (auf den vorliegend als Übergang B Bezug genommen wird) hat $X(z)$ die Form von $X_1(z)$ zum Zeitpunkt $m_0$-1, bzw. die Form von $X_2(z)$ zum Zeitpunkt $m_0$. Um dies zu erreichen, müssen in $X(z)$ die dazu passenden Nullen eingefügt werden; d.h. die passenden $R_i$ und $d_i$ müssen zu Null bzw. 1 gesetzt werden. Zum Zeitpunkt, zu welchem die Nullen am Eingang der Transformation erscheinen, werden die entsprechenden Zeilen von Nullen eingefügt. Dies führt zu einem unmittelbaren Umschalten der Unterabtastrate, und dies kann zu einer Anzahl der Bänder zu einem Zeitpunkt führen, die zwischen $N_1$ und $N_2$ liegt.

Der Übergang der Synthese ergibt sich entsprechend und durch die Bedingung der exakten Rekonstruktion.

Nachfolgend werden Ausführungsformen für Übergangsfilter auf Grundlage der erfindungsgemäßen Filterstrukturen erläutert.

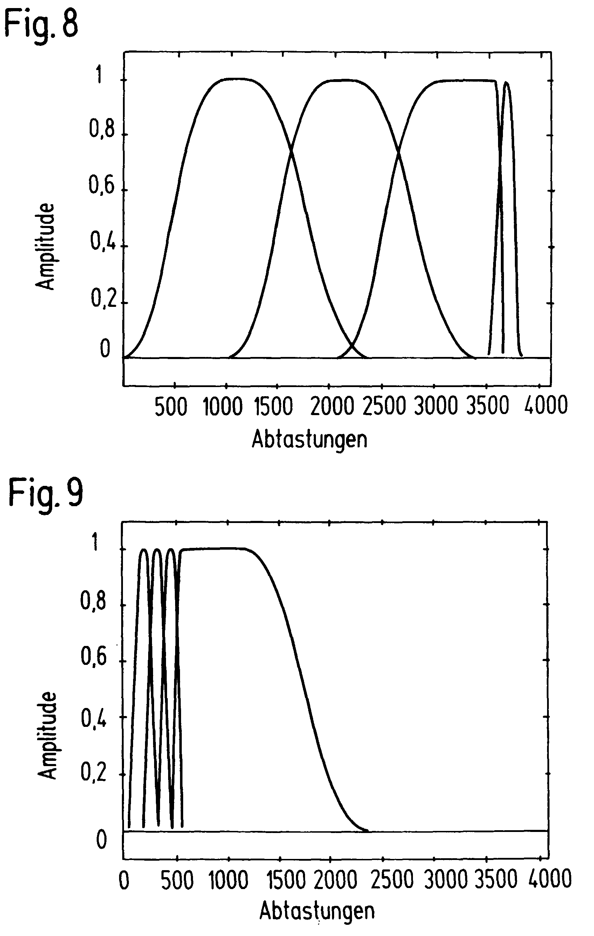

Eine Methode, modulierte Übergangsfilter für den Übergang zwischen verschiedenen Moden zu erhalten, besteht darin, dafür zu sorgen, daß die Verzögerungselemente, die zu Eingangswerten der Transformation beitragen, Werte mit gleichmäßigen zeitlichen Abständen enthalten. Dies kann beispielsweise dadurch erreicht werden, daß die Koeffizienten der Filtermatrizen zunächst zu Null gesetzt werden, wenn das Signal im neuen Modus sie erreicht. Das heißt, die Koeffizienten $b^0_0(m)$, ..., $b^0_{[N1/2]-1}(m)$ von $B_0$ zum Zeitpunkt $m = m_0$ gesetzt werden, wenn $\mu > 1$ ist, während die Koeffizienten von $H_i$ zu Null gesetzt zum Zeitpunkt $m = m_0 + i$ zu Null gesetzt werden, wobei gilt $i \leq \mu - 1$, während $L_i$ zum Zeitpunkt $m = m_0 + \mu$ zu Null gesetzt werden, wobei $i > 1$ gilt, bevor sie in den neuen Modus geschaltet werden. Dies hat die Wirkung, daß die zeitliche Überlappung der Impulsantworten zwischen Filtern verschiedener Moden auf eine Länge von $N_2$ begrenzt wird (siehe Figuren 8 und 9).

Die minimale Anzahl von Fenstern, die von einem Übergang betroffen sind, ist die Anzahl der sich zeitlich überlappenden Fenster oder Basisband-Impulsantworten entsprechend dem Längenfaktor L. Die Zeit vom Anfang eines Übergangs bis zu dem Zeitpunkt, wenn die Anzahl der Bänder sich im neuen Modus befindet, ist die Zeit, die das Signal mit dem neuen Modus benötigt, um die Verschiebungs- und Maximalverzögerungsmatrizen zu passieren.

Wenn $N_2 = 0$ ist, kann dieses Verfahren dazu verwendet werden, Filter für Grenzregionen eines Signals zu entwerfen. Filterbänke auf Grundlage dieser Filter können dazu verwendet werden, Signale mit endlicher Ausdehnung so zu verarbeiten, daß die Anzahl der von der Analyse-Filterbank erzeugten Werte genau der Anzahl der Werte im Signal entspricht, woraus das ursprüngliche Signal daraufhin perfekt rekonstruiert werden kann, und zwar einschließlich der Grenzregionen. Nicht veränderliche Filterbänke mit einer Filterlänge größer als N benötigen dazu entweder ein mit Nullen an den Enden aufgefülltes Signal, was jedoch die Anzahl der von der Analyse-Filterbank erhöht oder dazu führt, daß die Enden des Signals nicht perfekt rekonstruiert werden können.

Figur 8 zeigt die Impulsantworten des Synthese-Basisbandfilters für den Übergang A von 1024 Bändern zu 128 Bändern. Die erste Filterbank hat 1024 Bänder, eine Filterlänge von 4096 und eine System-Verzögerungszeit von 2047 Abtastwerten. Die zweite Filterbank hat 128 Bänder, eine Filterlänge von 512 und eine System-Verzögerungszeit von 255 Abtastwerten. Die Gesamtverzögerungszeit bleibt durch die Umschaltung konstant bei 2047 Abtastwerten, was für eine exakte Rekonstruktion notwendig ist, wobei die kürzere Filterbank implizit verzögert wird.

Figur 9 zeigt die Impulsantworten der Synthese-Basisbandfilter für den umgekehrten Übergang von 128 zu 1024 Bändern.

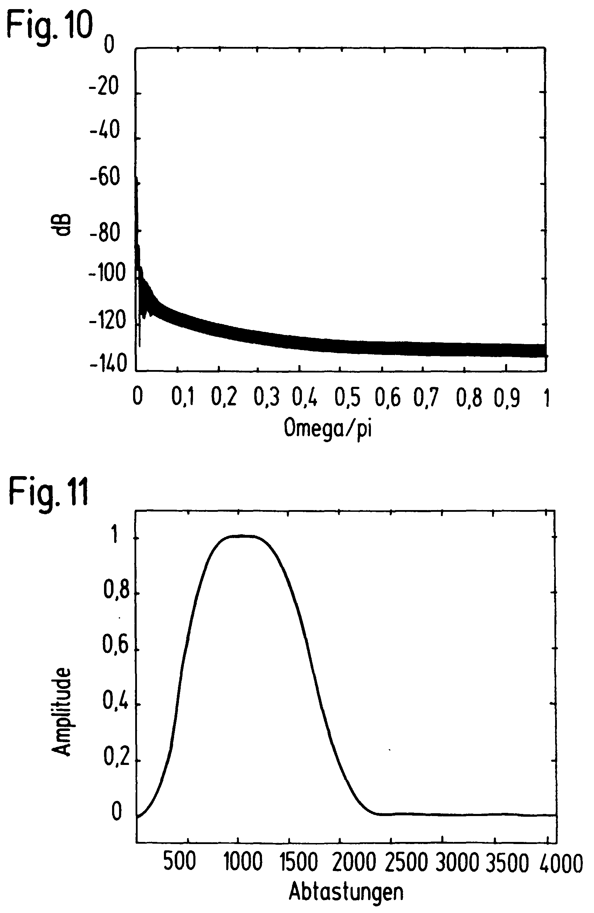

Die Figuren 10 und 11 zeigen das Basisbandfilter der Filterbank eines Modus mit 1024 Bändern, wobei das gleiche Basisbandfilter für die Analyse und für die Synthese verwendet wird.

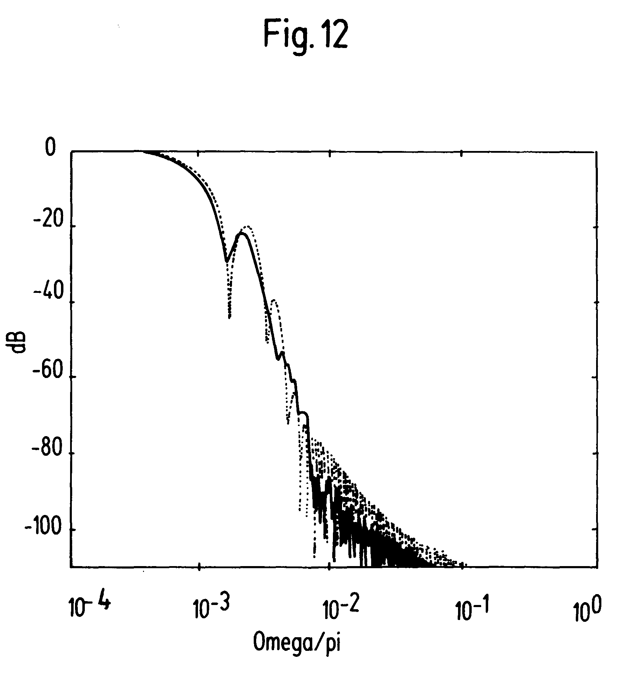

Figur 12 zeigt einen Vergleich dieses Filters mit dem ursprünglich im AAC-Kodierer benutzten Filter.

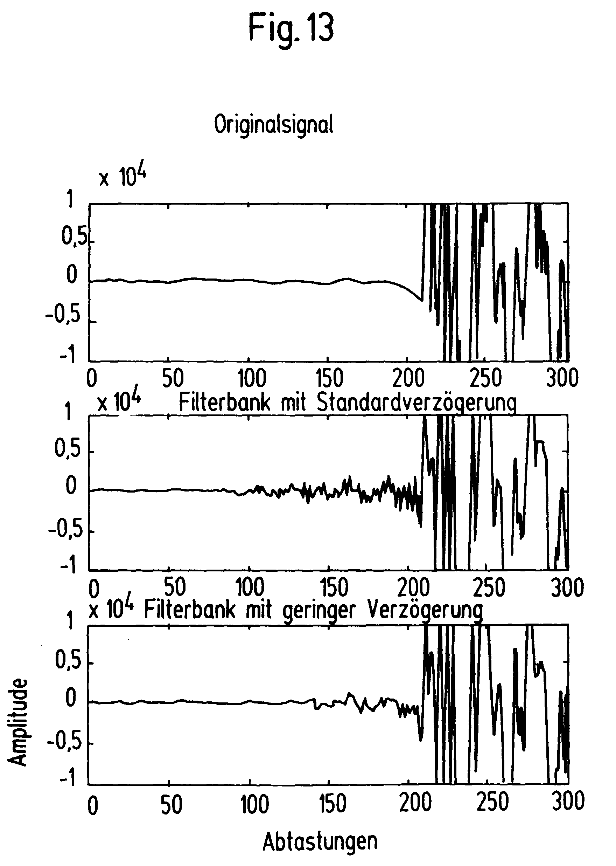

Figur 13 zeigt das durch die neue Filterbank wirksam reduzierte Vorecho, wobei im oberen Diagramm das Originalsignal bei Verwendung einer Filterbank mit Standardverzögerung (255 Abtastwerte im Modus von 128 Bändern) dargestellt ist, im mittleren Diagramm das Signal bei geringer Verzögerung der Filterbank und im unteren Diagramm das Signal bei Verwendung einer Filterbank mit einer niedrigen Verzögerung (191 Abtastwerte im 128 Band Modus).

# Zeichenerklärung

$x(n) - \boxed{\downarrow N} - y(m)$, Unterabtastung um den Faktor $N$, $y(m) = x(mN)$

$x(n) - \boxed{\uparrow N} - y(m)$, Überabtastung, $y(m) = \begin{cases} x(n) & \text{if } m = Nn \\ 0 & \text{otherwise} \end{cases}$

$a(n) - \oplus - c(n)$
$\quad\quad b(n)$
Addition, $c(n) = a(n) + b(n)$

$a(n) \quad \diagup \quad c(n)$
$\quad b(n)$

$x(n) \xrightarrow{\quad d \quad} y(n)$, Multiplikation mit $d$, $y(n) = d \cdot x(n)$

$x(n) \xrightarrow{\quad z^{-1} \quad} y(n)$, Verzögerungselement (Zwischenspeicher), $y(n) = x(n-1)$

$x(n) \xrightarrow{\quad z^{-1}a(n) \quad} y(n)$, Verzögerungselement mit anschl. mult., $y(n) = x(n-1) \cdot a(n)$

$x(n) \xrightarrow{\quad z \quad} y(n)$, Vorhersageelement, hebt die Wirkung eines daurauffolgenden oder vorhergegangenen Verzögerungselementes auf, $y(n) = x(n+1)$

$\Rightarrow$ Verbindung mit $N_1$ Leitungen

**Patentansprüche**

**1.** Verfahren zum Betreiben einer Filterbankanordnung zur datenreduzierten Kodierung von zeitlich veränderlichen Signalen, insbesondere Audiosignalen, mit einer von einem zu kodierenden Signal beaufschlagten und ein kodiertes Ausgangssignal erzeugenden Analyse-Filterbank und einer von diesem Ausgangssignal beaufschlagten Synthese-Filterbank zur Rekonstruktion des ursprünglichen Signals, wobei die Analyse-Filterbank und die Synthese-Filterbank jeweils N (N > 1) Filter aufweisen, die auf einem Basisband-Prototypfilter basieren und entweder eine Filterlänge L größer als 2N haben oder die so ausgelegt sind, daß bei einer Filterlänge L > N die Filter der Analyse-Filterbank nicht orthogonal zu den Filtern der Synthese-Filterbank sind, **dadurch gekennzeichnet**, daß die Filterbänke in Kombination bzw. alternativ wie folgt betrieben werden:

a) die Filteranzahl N wird in Abhängigkeit vom Signal während der Signalverarbeitung in den Filterbänken geändert (vergrößert bzw. verkleinert),
b) die Filterlänge L wird in Abhängigkeit vom Signal während der Signalverarbeitung in den Filterbänken geändert (vergrößert bzw. verkleinert),
c) die Filterstruktur wird in Abhängigkeit vom Signal während der Signalverarbeitung in den Filterbänken geändert (vergrößert bzw. verkleinert),
wobei in der Betriebsart a) und/oder b) während der Umschaltung der Filteranzahl N die Filterimpulsanworten, die zu Filterbänken mit unterschiedlichen N gehören, sich überlappend ausgegeben werden.

2. Verfahren nach Anspruch 1, **dadurch gekennzeichnet**, daß die Analyse-Filterbank und die Synthese-Filterbank, falls sie direkt miteinander verbunden betrieben werden, ein Signal exakt rekonstruieren.

3. Verfahren nach Anspruch 1 oder 2, **dadurch gekennzeichnet**, daß die Filteranzahl konstant gehalten und die Filterlänge in Abhängigkeit vom Signal geändert wird, wenn die Filter der Analyse-Filterbank nicht orthogonal zu den Filtern der Synthese-Filterbank sind.

4. Verfahren nach Anspruch 1, 2 oder 3, **dadurch gekennzeichnet**, daß unter den Filtern ein Satz unterschiedlicher Paare von Prototyp-Filtern festgelgt wird, von denen in Abhängigkeit von Signaländerungen jeweils ein Paar zur Signalverarbeitung gewählt wird, dem eine Kennungszahl zugeordnet wird, die zusammen mit dem Ausgangssignal der Analyse-Filterbank zur Synthese-Filterbank übertragen wird.

5. Filterbankanordnung zur Durchführung des Verfahrens nach einem der Ansprüche 1 bis 4, **dadurch gekennzeichnet**, daß die Analyse-Filterbank aus hintereinandergeschalteten Filtermatrizen besteht und mathematisch als Matrizen und Matrixmultiplikationen beschrieben folgende Struktur aufweist:

$$P_a(z,m) :=$$

$$= S^{n_a}(z) \cdot B_0(z,m) \cdot \prod_{i=1}^{\mu-1} H_i(z,m) \cdot \prod_{j=1}^{\nu} L_j(z,m) \cdot T_a(m) \qquad (1),$$

wobei **H**$_i$ und **L**$_i$ definiert sind als

$$H_i(z,m) := B_i(z,m),$$

wenn $i_a = 0$; ansonsten gilt

$$H_i(z,m) := A_i(z,m),$$

$$L_i(z,m) := E_i(z,m),$$

wenn $i_a = 0$ und $\mu$ gerade ist, oder $i_a = 1$ und $\mu$ ungerade ist; ansonsten gilt:

$$L_i(z,m) := G_i(z,m).$$

Bei **T**$_a$(m) handelt es sich um eine Transformationsmatrix der Größe N x N. Die Parameter $\mu > 0$ und $\nu \geq 0$ können frei gewählt werden. Diese Parameter bestimmen die Filterlänge und mit $n_a$, $n_s$ die Systemverzögerungszeit. $i_a$

kann frei gewählt werden als 1 oder 0, hat aber keinen wesentlichen Einfluß auf die Filtercharakteristik. $0 \leq n_a \leq N$ kann zur Feineinstellung der Systemverzögerungszeit in Schritten der Eingangsabtastrate herangezogen werden und wobei gilt:

$$E_i(z, m) := J + z^{-1} \cdot \mathrm{diag}(\underbrace{0, \ldots, 0}_{\lceil N/2 \rceil}, e^i_{\lceil N/2 \rceil}(m), \ldots, e^i_{N-1}(m))$$

$$G_i(z, m) := J + z^{-1} \cdot \mathrm{diag}(g^i_0(m), \ldots, g^i_{\lfloor N/2 \rfloor - 1}(m), 0, \ldots, 0)$$

$$A_i(z, m) := z^{-1} \cdot J + \mathrm{diag}(0, \ldots, 0, a^i_{\lceil N/2 \rceil}(m), \ldots, a^i_{N-1}(m))$$

$$B_i(z, m) := z^{-1} \cdot J + \mathrm{diag}(b^i_0(m), \ldots, b^i_{\lfloor N/2 \rfloor - 1}(m), 0, \ldots, 0)$$

$$B_0(z) := [z^{-1} \cdot \mathrm{diag}(b^0_N(m), \ldots, b^0_{2N-1}(m)) \cdot J +$$

$$+ \mathrm{diag}(b^0_0(m), \ldots, b^0_{\lfloor N/2 \rfloor - 1}(m), 0, \ldots, 0)] \cdot J^{i_a}$$

6. Filterbankanordnung nach Anspruch 5, **dadurch gekennzeichnet**, daß eine Analyse-Unterabtastung und - Filterung festgelegt ist als:

$$Y(z) = X(z) \cdot P_a(z, m)$$

7. Filterbankanordnung nach Anspruch 5 oder 6, **dadurch gekennzeichnet**, daß die Synthesefilterbank aus hintereinandergeschalteten Filtern besteht und mathematisch als auf die Analyse-Filterbank bezogen inverse Matrizen und Matrixmultiplikationen beschrieben folgende Struktur aufweist:

$$P_s(z, m) :=$$

$$T_s(m) \cdot \prod_{j=\nu}^{1} L_j^{-1}(z, m) \cdot \prod_{i=\mu-1}^{1} \left( H_i^{-1}(z, m - 2(\mu - 1 - i))z^{-2} \right) \cdot$$

$$\cdot \left( B_0^{-1}(z, m - 2(\mu - 1))z^{-2} \cdot S^{n_s}(z) \right)$$

$$(2)$$

wobei

$$T_a(m) \cdot T_e(m) = I.$$

8. Filterbankanordnung nach Anspruch 7, **dadurch gekennzeichnet**, daß eine Synthese-Überabtastung und - Filterung festgelegt ist als:

$$\hat{X}(z) = Y(z) \cdot P_s(z, m)$$

wobei $0 \leq n_s \leq n_a$.

$$\hat{X}(z) = Y(z) \cdot P_s(z, m)$$

# Fig.1

# Fig.2

# Fig. 3

# Fig. 4

# Fig. 5

$$X \to \boxed{S^{n_a} \cdot B_0} \to \boxed{H_1} \to \cdots \to \boxed{H_{\mu-1}} \to$$

$$\to \boxed{L_1} \to \cdots \to \boxed{L_\gamma} \to \boxed{T_a} \to Y$$

$$Y \to \boxed{T_a^{-1}} \to \boxed{L_\gamma^{-1}} \to \cdots \to \boxed{L_1^{-1}} \to$$

$$\to \boxed{H_{\mu-1}^{-1} z^{-2}} \to \cdots \to \boxed{H_1^{-1} z^{-2}} \to \boxed{B_0^{-1} z^{-2} \cdot S^{n_5}} \to \hat{X}$$

# Fig. 6

# Fig. 7

Fig. 8

Fig. 9

Fig. 10

Omega/pi

Fig. 11

Abtastungen

# Fig. 12

# Fig. 13

Originalsignal

Filterbank mit Standardverzögerung

Filterbank mit geringer Verzögerung

Amplitude

Abtastungen